# EUROPEAN PATENT SPECIFICATION

(11) **EP 0 851 429 B1**
(45) Date of publication and mention of the grant of the patent: **17.12.2003**
(21) Application number: 97109419.8
(22) Date of filing: 10.06.1997
(51) Int. Cl.: G11C 11/56

(54) **Data sensing device and method for multibit memory cell**
Datenlesevorrichtung und -verfahren für Mehrbitspeicherzelle
Dispositif de détection de données et méthode pour cellule de mémoire multibit

(30) Priority: 30.12.1996 KR 9676873
(43) Date of publication of application: 01.07.1998
(73) Proprietor: LG Semicon Co., Ltd., Cheongju-si, Chungcheongbuk-do (KR)
(72) Inventor: Choi, Woong Lim, Cheongju-si, Chungcheongbuk-do (KR)
(74) Representative: TER MEER STEINMEISTER & PARTNER GbR

(56) References cited:
- WO-A-97/13250
- US-A- 5 457 650
- US-A- 5 508 958
- JUNG T -S ET AL: "A 117-MM2 3.3-V ONLY 128-MB MULTILEVEL NAND FLASH MEMORY FOR MASS STORAGE APPLICATIONS" November 1996 , IEEE JOURNAL OF SOLID-STATE CIRCUITS, VOL. 31, NR. 11, PAGE(S) 1575 - 1583 XP000691441 * page 1577, right-hand column, line 33 - page 1578, right-hand column, line 2 *

## Description

### BACKGROUND OF THE INVENTION

### Field of the Invention

The present invention relates to device and method for reading in information stored in a semiconductor device and, more particularly, to a data sensing device and method for a multibit memory cell for reading in a data programmed in multilevel of two or over two levels stored in the multibit memory cell.

### Discussion of the Related Art

In the semiconductor memories, in general, there are at large volatile memories from/to which information is erasable and recordable, and non-volatile memories information once recorded in which can be conserved permanently. In the volatile memories, there are RAM to/from which data is recordable and readable, and in the non-volatile memories, there are ROM, EPROM(Erasable Programmable ROM) and EEPROM(Electrically Erasable Programmable ROM). Of the non-volatile memories, the ROM is a memory which is no more programmable once information is recorded, and both the EPROM and EEPROM are memories from/to which information is erasable and recordable. The EPROM and EEPROM are identical in their programming operations, but different in their information erasing operations; the information recorded in EPROM is erased by an ultra-violet beam and the information stored in EEPROM is electrically erased.

Of those memories, the DRAM is the most widely used as a mass storage media because large sized memories are required as the information industry is developed. However, the DRAM, which requires a storage capacitor of greater than a predetermined size, has a disadvantage that refreshing operations of the capacitor are required in certain intervals due to the use of capacitor. Because of this, there has been ceaseless study on the EEPROM, which does not require any refreshing operations, in substitution for the DRAM. However, since the EEPROM can also store data of either "1" or "0" in a memory cell, device packing density corresponds to a number of the memory cells in one to one fashion. Therefore, the drawback in using the EEPROM as a data storage media that is the most difficult to overcome is the high cost-per-bit of the memories.

In order to solve such a problem, active studies on multibit-per-cell are currently underway. A multibit memory cell stores data of over two bits in one memory cell, thus enhancing the density of data on the same chip area without reducing the size of the memory cell. For the multibit memory cell, more than two threshold voltage levels should be programmed on respective cell. For instance, in order to store data of two bits for every cell, the respective cells must be programmed in 2², that is, four threshold levels. Here, the four threshold levels corresponds to logic states 00, 01, 10 and 11, respectively. As distribution is reduced by precisely adjusting the respective threshold levels, more levels can be programmed, which in turn increases the number of bits for every cell. The data thus programmed in multilevels should be read in fast speed.

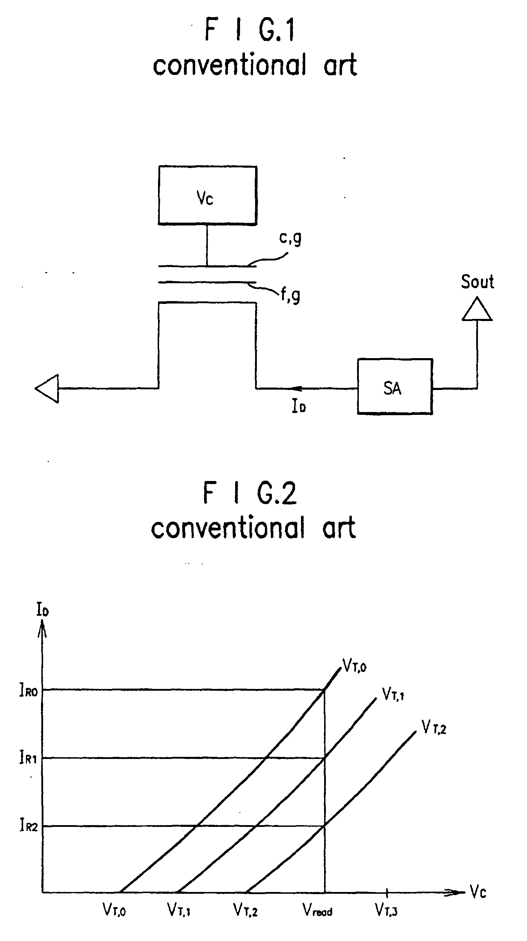

A conventional data sensing device for sensing a memory cell programmed in such a multilevels will be explained with reference to the attached drawing. Fig. 1 illustrates a system of a conventional sensing device for sensing a multibit memory cell, and Fig. 2 illustrates a graph explaining the operation of the conventional sensing device for sensing a multibit memory cell. When voltages sufficient to cause reading are applied to a control gate, a current flows between a drain and a source. The current is compared to a reference current and determined of the data in reading the multilevel data. Referring to Fig. 1, a system is provided having a sensing amplifier(S.A) connected to a drain region D in a unit cell of an EEPROM with a floating gate F.G., control gate C.G., source region S and the drain region D. The sensing amplifier S.A. has a plurality of reference currents therein.

A method of sensing the data in the conventional multibit memory cell having the aforementioned system will be explained.

It is assumed that the memory cell has been programmed in multilevel threshold voltages. That is, as shown in Fig. 2, in case of recording a two bit data, it is assumed that the two bit data has been programmed in the floating gate F.G. as one of four threshold voltages V_{T0}, V_{T1}, V_{T3}, V_{T4}. Under the condition that a constant voltage is applied to the source region S, a predetermined voltage V_{READ} is selectively applied to the control gate C.G. ofa memory cell of which data is intended to read. Then, according to the programmed state in the floating gate F. G., a drain current I_{D} corresponding to the programmed state flows through the sensing amplifier S.A. The sensing amplifier S.A. compares the drain current from the memory cell to the multilevel reference currents within the sensing amplifier S.A in multilevels, thereby the data can be read. That is, referring to Fig. 2, if the floating gate F. G. of a memory cell in an EEPROM from which a data is intended to read has been programmed in the threshold voltage V_{T0}, a drain current I_{R0} corresponding to the threshold voltage V_{T0} will flow through the sensing amplifier S.A., if the floating gate F. G. has been programmed in the threshold voltage V_{T1}, a drain current corresponding to the threshold voltage V_{T1} will flow through the sensing amplifier S.A., and if the floating gate F. G. has been programmed in the threshold voltage V_{T2}, a drain current corresponding to the threshold voltage V_{T2} will flow through the sensing amplifier S.A. Therefore, upon reception of the drain current from the drain of the memory cell, the sensing amplifier S.A. can sense the data by comparing the drain current with the multilevel reference currents within the sensing amplifier SA.

However, the conventional data sensing device and method for sensing a data in a multibit memory cell has the following problems because a predetermined voltage Vc of a readable condition is applied to the control gate of a memory cell from which a data is intended to read in selection of the memory cell, and the drain current from the memory cell is compared in multilevels in the sensing amplifier in reading the data.

First, for the multilevel comparison of the current from the memory cell by the sensing amplifier in reading the data, the sensing amplifier must have the multilevel reference currents, that causes the size of the sensing amplifier bigger, particularly in a page mode READ, in which more bits(for example, 512 bits, 128 bits) are required, together with chip size.

Second, the plurality of reference currents always required to supply to the sensing amplifier causes increase of power consumption.

US 5,508,958 shows a device for sensing data in multibit memory cell that comprises a reference voltage generating part consisting of a counter and a digital-to-analog converter, a sensing part consisting of sense amplifiers for detecting whether or not a channel has been formed in a memory cell due to the applied reference voltage. Further, this known device comprises a latching part that receives the output signal of counter of the reference voltage generating part as data signal. In case that the reference voltage applied to the control gate of a memory cell is higher than the programmed treshold voltage the sense amplifier supplies an output signal to the latch circuit to latch the data for outputting the programmed data of the respective memory cell.

### SUMMARY OF THE INVENTION

It is an object of the present invention to provide a device and a method for sensing data in a multibit memory cell that makes it possible to simplify the reference voltage generator necessary for producing different reference voltages and to speed up the sensing operation as such at least to a certain extent.

This object is achieved by the device according to claim 1 and the method according to claim 8.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the drawings:

In the drawings:
Fig. 1 illustrates a system of a conventional sensing device for sensing a multibit memory cell;
Fig. 2 illustrates a graph for use in explaining the operation of the conventional sensing device for sensing a multibit memory cell;
Fig. 3 illustrates a block diagram of a device for sensing a data in a multibit memory cell in accordance with a first embodiment of the present invention;
Fig. 4 illustrates a detail circuit of a first embodiment of the switching part shown in Fig. 3;
Fig. 5 illustrates a detail circuit of a second embodiment of the switching part shown in Fig. 3 ;
Fig. 6 illustrates a detail circuit of the clock signal controlling part shown in Fig. 3;
Fig. 7 illustrates a detail circuit of the latching part shown in Fig. 3;
Fig. 8 illustrates a block diagram of a device for sensing a data in a multibit memory cell in accordance with a second embodiment of the present invention;
Fig. 9 explains threshold levels of an n bit cell and the corresponding reference voltages in accordance with the present invention;
Fig. 10 explains reference voltage selection in the first embodiment of the present invention;
Fig. 11 explains reference voltage selection in the second embodiment of the present invention;
Fig. 12 explains timings of different parts when the memory cell of the present invention is programmed in a threshold level V_{TH2}; and,
Fig. 13 explains timings of different parts when the highest level data is read according to the present invention.

### DETAILED DESCRIPTION OF THE PREFERRED EMBODIMENTS

Reference will now be made in detail to the preferred embodiments of the present invention, examples of which are illustrated in the accompanying drawings.

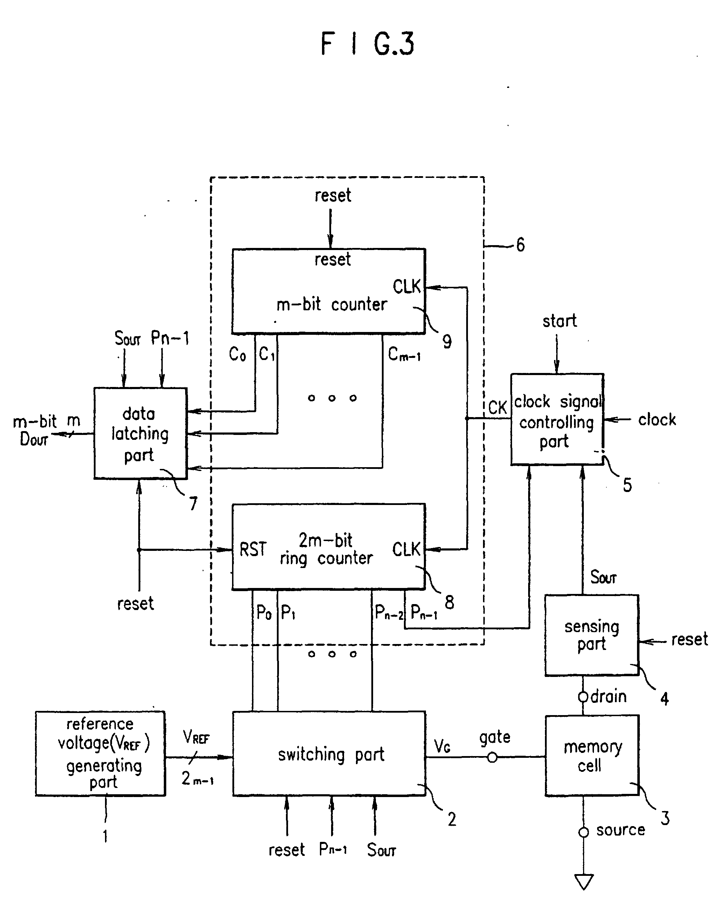

Fig. 3 illustrates a block diagram of a device for sensing a data in a multibit memory cell in accordance with a first embodiment of the present invention.

Referring to Fig. 3, the device for sensing a data in a multibit memory cell in accordance with a first embodiment of the present invention includes a reference voltage generating part 1 for generating a plurality of reference voltages(2ⁿ-1 in case of n bits), a switching part 2 for applying the plurality of reference voltages from the reference voltage generating part 1 to a control gate in a memory cell 3 in succession under the control of the controlling part which will be explained later, a sensing part 4 for comparing the data recorded in the memory cell 3 having one of the reference voltage applied thereto to a reference value, a clock signal controlling part 5 for receiving a signal from the sensing part 4 and a highest voltage selection signal from a controlling part which will be explained below and subjecting to logical operation in controlling an external main clock signal, a controlling part 6 for applying a reference voltage selection signal to the switching part 2 to control the reference voltages generated in succession(in the order of from a lower reference voltage to a higher reference voltage or vice versa) and producing a data in response to a clock signal from the clock signal controlling part 5, and a data latching part 7 for latching the data from the controlling part 6.

The controlling part 6 includes a ring counter 8 for counting the clock signal from the clock signal controlling part 5 in generating the reference signal selection signals P₀, P₁ --- Pₙ₋₂, and Pₙ₋₁, and an n-bit counter 9 for counting the clock signal from the clock signal controlling part 5 in producing a relevant data.

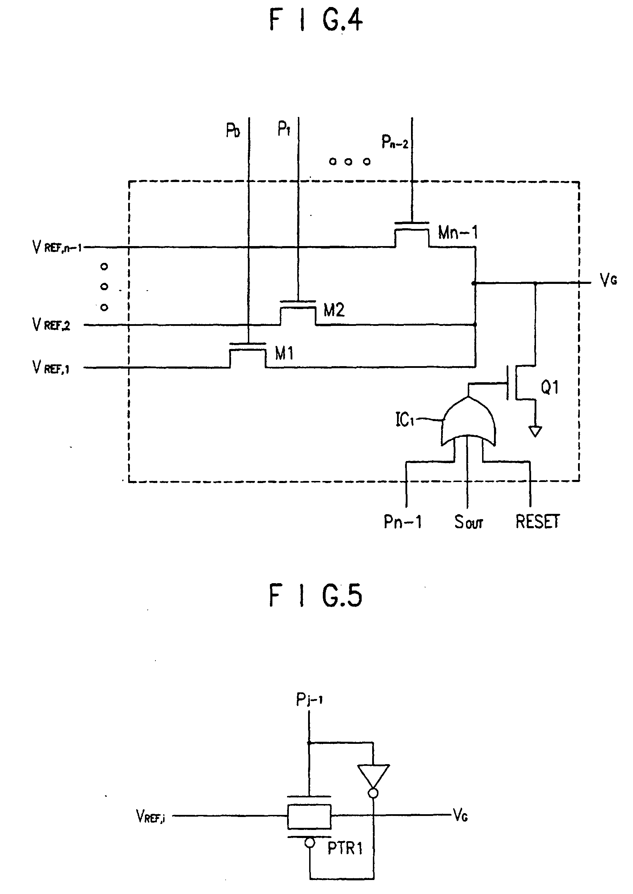

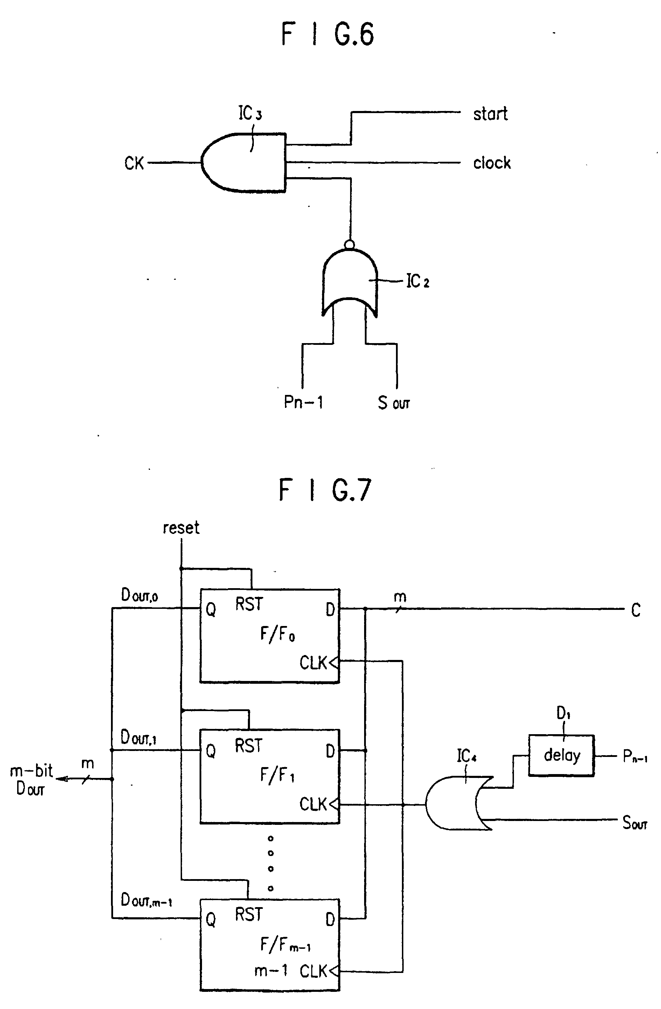

Detailed circuits of the aforementioned device for sensing a data in a multibit memory cell will be explained. Fig. 4 illustrates a detail circuit of a first embodiment of the switching part shown in Fig. 3, Fig. 5 illustrates a detail circuit of a second embodiment of the switching part shown in Fig. 3, Fig. 6 illustrates a detail circuit of the clock signal controlling part shown in Fig. 3, and Fig. 7 illustrates a detail circuit of the latching part shown in Fig. 3.

Referring to Fig. 4, the switching part I includes a plurality of transistors M₁, M₂, ---, Mₙ₋₁ each for switching the plurality of reference voltages from the reference voltage generating part 1 in succession in response to the reference voltage selection signals P₀, P₁, P₂, --- and Pₙ₋₂ except the highest reference voltage selection signal Pₙ₋₁ of the reference voltage selection signals P₀, P₁ --- Pₙ₋₂, and Pₙ₋₁ from the controlling part 6, an OR gate IC₁ for subjecting the highest reference voltage selection signal Pₙ₋₁ from the controlling part 6, a signal S_{OUT} from the sensing part 4 and a reset signal RESET to a logical sum operation, and a transistor Q₁ for switching the reference voltages applied to an output terminal thereof from the plurality of transistors M₁, M₂, ---, Mₙ₋₁ in response to a signal from the OR gate IC₁. The switching part 2 may include a plurality of pass transistors PTR₁ as shown in Fig. 5 in place of the plurality of transistors M₁, M₂, ---, Mₙ₋₁ shown in Fig. 4, each of which produces the reference signal at "high".

Referring to Fig. 6, the clock signal controlling part 5 includes an NOR gate IC₂ for subjecting the highest reference voltage selection signal Pₙ₋₁ from the controlling part 6 and the signal S_{OUT} from the sensing part 4 to a logical sum operation and inverting a resultant of the logical sum operation, and an AND gate IC₃ for subjecting a start signal START, external main clock signal CLOCK and a signal from the NOR gate IC₂ to a logical production operation in applying the clock signal to the controlling part 6.

Referring to Fig. 7, the latching part 7 includes a plurality of flipflops. That is, the latching part 7 includes a delay D₁ for delaying the highest reference voltage selection signal Pₙ₋₁ for a predetermined time period, an OR gate IC₄ for subjecting a signal from the delay D₁ and the signal S_{OUT} from the sensing part 4 to a logical sum operation, and the plurality of flipflops F/F₀, F/F₁, ---, F/Fₙ₋₁ for latching the data from the n-bit counter 9 in the controlling part 6 using a signal from the OR gate IC₄ as a clock signal.

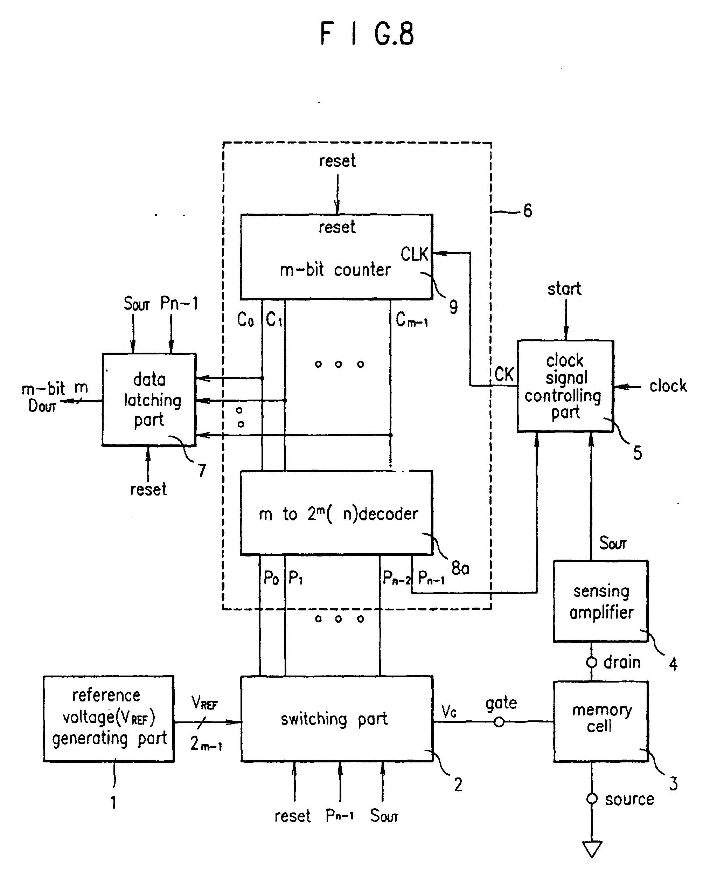

Fig. 8 illustrates a block diagram of a device for sensing a data in a multibit memory cell in accordance with a second embodiment of the present invention.

Referring to Fig. 8, the device for sensing a data in a multibit memory cell in accordance with a second embodiment of the present invention has a decoder 8a for decoding the plurality of reference signal selection signals in place of the ring counter 8 in the controlling part 6 of the device for sensing a data in a multibit memory cell in accordance with the first embodiment of the present invention.

A sensing method in the device for sensing a data in a multibit memory cell in accordance with the present invention will be explained.

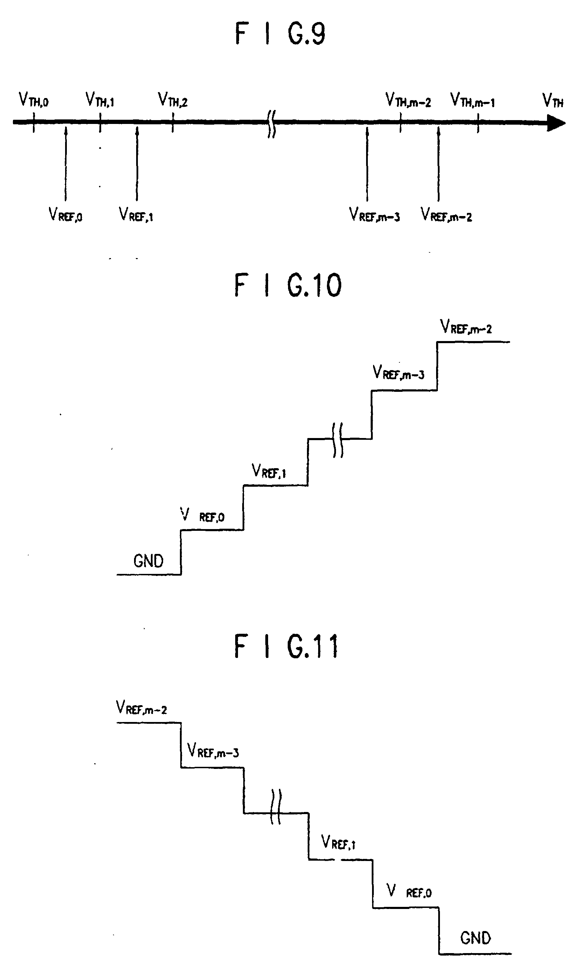

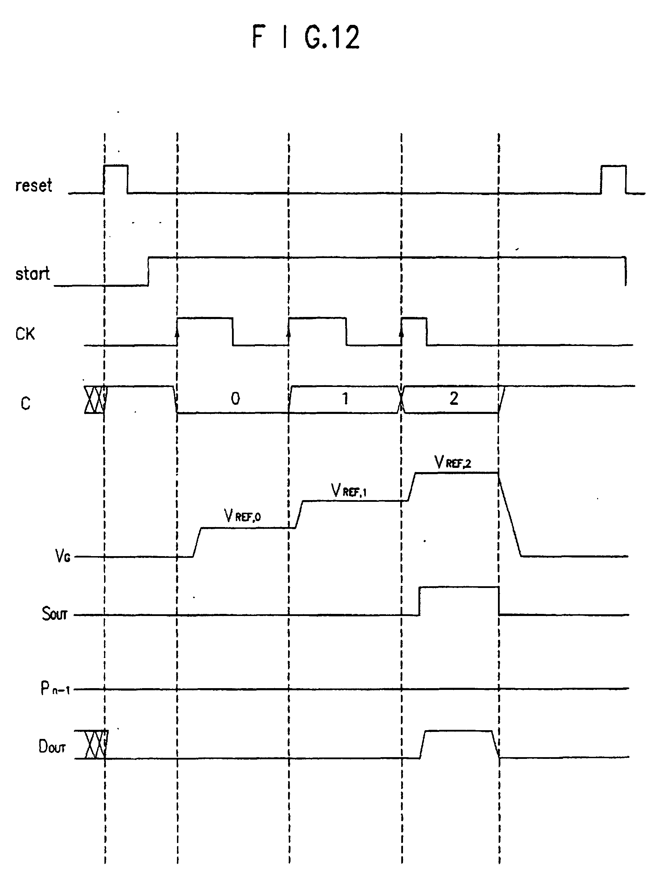

Fig. 9 explains threshold levels of an n bit cell and the corresponding reference voltages in accordance with the present invention, Fig. 10 explains reference voltage selection in the first embodiment of the present invention, and Fig. 11 explains reference voltage selection in the second embodiment of the present invention.

A value between adjacent threshold levels is taken as the reference voltage. For example, if the threshold levels are 2, 4, 6, 8, the reference voltages may be 3, 5, 7. Accordingly, the reference voltage generating part 1 generates 2ⁿ-1 number of voltages each corresponding to an intermediate value of adjacent threshold voltage levels in case of an n bit memory cell. The controlling part 6 controls the switching part 2 to output the reference voltages from the reference voltage generating part 1 in succession. In this instance, if the threshold levels are n bits, though a 2ⁿ-1 number of reference voltages is required, a number of the reference voltage selection signals from the controlling part 6 is 2ⁿ. Therefore, the reference voltages are actually selected by the reference voltage selection signals P₀, P₁, P₂, --- and Pₙ₋₂, but the highest reference voltage selection signal Pₙ₋₁. That is, the controlling part 6 controls the switching part 2 to output the reference voltages in an order of from a lower voltage to a higher voltage as shown in Fig. 10, or from a higher voltage to a lower voltage as shown in Fig. 11, by the following method.

When the ring counter 8 or the decoder 8a in the controlling part 8 generates the high reference voltage selection signals in the order of from P₀ to Pₙ₋₁, the transistors M₁, M₂, ---, Mₙ₋₁ in the switching part 2 having the high signals applied thereto are turned on to output the reference voltages in the order of from a lower voltage to a higher voltage as shown in Fig. 10. In this instance, of the reference voltage selection signals from the controlling part 6, the highest reference voltage selection signal Pₙ₋₁ is applied, not to any of the transistors in the switching part 2, but to the OR gate IC₁ in the switching part 2, clock signal controlling part 5 and the latching part 7. Therefore, in case the reference voltages are produced in the order of from lower reference voltage to higher reference voltage as shown in Fig. 10, the highest reference voltage is produced by the reference voltage selection signal Pₙ₋₂. Oppositely, when the ring counter 8 or the decoder 8a in the controlling part 8 generates the high reference voltage selection signals in the order of from Pₙ₋₂ to P₀, and the Pₙ₋₁ finally, the transistors M₁, M₂, ---, Mₙ₋₁ in the switching part 2 having the high signals applied thereto are turned on to output the reference voltages in the order of from a higher voltage to a lower voltage as shown in Fig. 11. For reduction of power consumption, it is preferable to produce the reference voltages in the order of from lower reference voltage to higher reference voltage as shown in Fig. 10, because, at reading data, the data may be sensed, not always by selecting up to the last reference voltage, but by selecting an intermediate reference voltage.

When the reference voltages are thus applied from the switching part 2 to the control gate on the memory cell 3 in succession, the sensing part makes turning on/off operations. In this instance, a channel is formed between a source region and a drain region in the memory cell 3 in case a reference voltage over a threshold level is applied to the control gate, and no channel is formed between the source region and the drain region in the memory cell 3 in case a reference voltage below a threshold level is applied to the control gate. Accordingly, the sensing part 4 also produces a high signal when a reference voltage over a threshold level is applied to the control gate, and a low signal when a reference voltage below a threshold level is applied to the control gate. For explaining it in detail, it is assumed that the controlling part 6 applies the reference voltages to the control gate on the memory cell 3 in the order of from lower reference voltage to higher reference voltage as shown in Fig. 10, the memory cell has been programmed in one of the two bit threshold levels V_{TH, 0}, V_{TH, 1}, V_{TH, 2} and V_{TH, 3}, and there are three of the reference voltages V_{REF, 0}, V_{REF, 1} and V_{REF, 2} each of which value falls on between adjacent two of the threshold levels. Upon the reference voltage V_{REF, 0} is applied to the control gate on the memory cell 3 by the switching part 2, the sensing part 4 produces a high signal only when the memory cell has been programmed in the threshold level V_{TH, 0} because the channel will be formed between the source region and the drain region of the memory cell, and the sensing part 4 produces a low signal when the memory cell has been programmed in one of the rest of the threshold levels V_{TH,} ₁, V_{TH, 2} and V_{TH, 3}. Alikely, upon the reference voltage V_{REF, 2} is applied to the control gate on the memory cell 3 by the switching part 2, the sensing part 4 produces a low signal only when the memory cell has been programmed in the threshold level V_{TH, 3} because the channel will not be formed between the source region and the drain region of the memory cell, and the sensing part 4 produces a high signal when the memory cell has been programmed in one of the rest of the threshold levels V_{TH, 0}, V_{TH, 1} and V_{TH, 2}. By determining an output of the sensing part 4 whenever one of the reference voltages is applied to the control gate on the memory cell while elevating the reference voltage from the lowest voltage to the highest voltage in succession according to the aforementioned principle, and by counting a time point when the output of the sensing part 4 is 'changed to "high", the device of the present invention senses a data in the multibit memory cell.

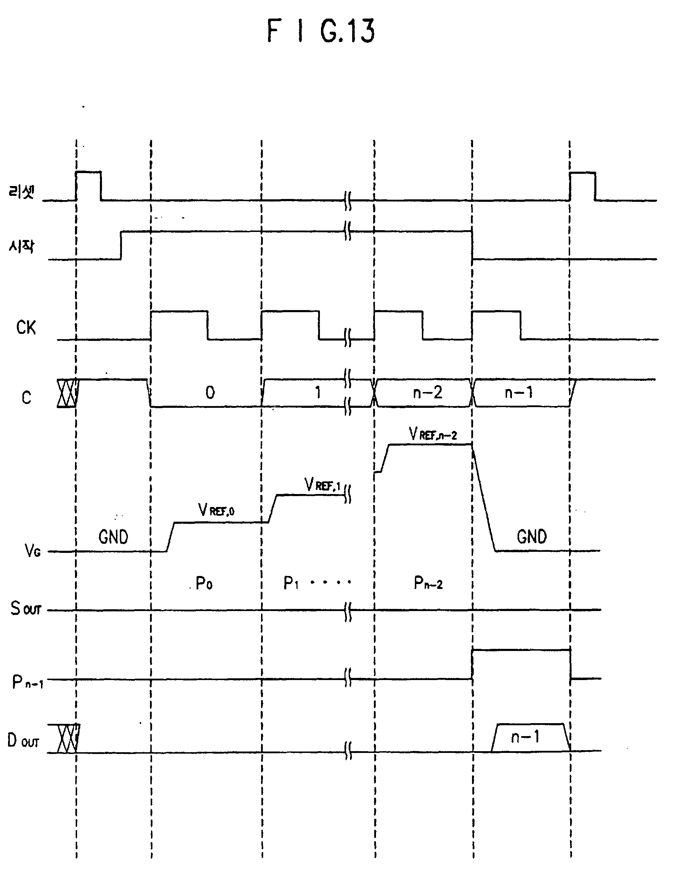

A sensing method of the device for sensing a data in a multibit memory cell in accordance with the first embodiment of the present invention will be explained with reference to Figs. 12 and 13. Fig. 12 explains timings of different parts when the memory cell of the present invention is programmed in a threshold level V_{TH2}, and Fig. 13 explains timings of different parts when the highest level data is read according to the present invention.

Upon reception of an external main clock signal CLOCK, then, a reset signal RESET and a start signal START, the clock signal controlling part 5 produces a clock signal to the controlling part 6. The controlling part 6 then counts the clock to generates a reference voltage selection signal and a 2 bit data signal. That is, the ring counter 8 in the controlling part 6 causes the lowest reference voltage V_{REF, 0} to be produced and applied to the memory cell 3 through the switching part 2, and the n bit counter 9 in the controlling part 6 produces a data 00. Upon reception of the reference voltage V_{REF, 0} thus, since the memory cell 3 is programmed in the threshold level V_{TH,} _{2,} the sensing part 4 produces a low signal. As all of the signal S_{OUT} from the sensing part 4 and the reference voltage selection signal Pₙ₋₁ from the controlling part 6 are at "low", the NOR gate IC₂ in the clock signal controlling part 6 produces a high signal, so that the AND gate IC₃ in the clock signal controlling part 5 continues to apply the external main clock signal CLOCK to the controlling part 6. The controlling part 6, counting the clock signal applied thereto continuously according to the aforementioned process, proceeds the next operation. That is, the controlling part 6 controls the ring counter 8 to produce the reference voltage selection signal P₁ at a second rising edge of the clock signal for producing the next reference voltage V_{REF, 1}, the reference voltage V_{REF, 1} produced in the reference voltage generating part 1 to be applied to the memory cell 3, and the n bit counter 9 to produce the data 01. Even if the reference voltage V_{REF, 1} is received, the sensing part 4 produces a low signal because the memory cell 3 has been programmed in the threshold level V_{TH, 2}. As all of the signal S_{OUT} from the sensing part 4 and the reference voltage selection signal Pₙ₋₁ from the controlling part 6 are at "low", the NOR gate IC₂ in the clock signal controlling part 6 produces a high signal, so that the AND gate IC₃ in the clock signal controlling part 5 continues to apply the external main clock signal CLOCK to the controlling part 6. Then, the controlling part 6 controls the ring counter 8 and the n bit counter 9 to cause the reference voltage V_{REF, 2} generated in the reference signal generating part 1 to be applied to the memory cell 3 through the switching part 2 and to produce the data 10 respectively at a third rising edge of the clock signal Upon reception of the reference voltage V_{REF, 2}, the sensing part 4 produces a high signal because the memory cell 3 has been programmed in the threshold level V_{TH, 2}. As the signal S_{OUT} from the sensing part 4 is the high signal, the NOR gate IC₂ in the clock signal controlling part 5 produces a low signal regardless of the reference voltage selection signal Pₙ₋₁ from the controlling part 6. Therefore, the AND gate IC₃ in the clock signal controlling part 5 applies no external main clock signal CLOCK to the controlling part 6. If no clock signal is applied to the controlling part 6, all the parts of the sensing device are initialized, and the latching part 7 presents the data 10 finally produced in the n bit counter 9 of the controlling part 6 as a sensed data.

According to the aforementioned method, a 2ⁿ-1 number of level values are sensed except the highest level value in the multilevel programmed memory cell, and the remained one highest level value is sensed by a method as shown in Fig. 13.

That is, if the memory cell has been programmed in the highest threshold level V_{TH, 3}, even if the controlling part 6 produces a reference voltage selection signal to apply the highest reference voltage V_{REF,2} to the memory cell 3, the sensing part 4 produces a low signal. When the sensing part 4 thus produces the low signal, the clock signal controlling part 5 also continues to apply the external clock signal to the controlling part 6. Then, the ring counter 8 and the n bit counter 9 in the controlling part 6 respectively count the clock signal to produce the highest reference voltage selection signal Pₙ₋₁ at "high" and to apply the data 11 to the latching part 7 at a fourth rising edge of the clock signal, respectively. The NOR gate IC₂ in the clock signal controlling part 5 then produces a low signal to stop application of the external clock signal to the controlling part 6 even if the low signal is under production in the sensing part 4. According to the aforementioned method, the latching part 7 can present a final data 11.

On the other hand, the sensing method of the device for sensing a data in a multibit memory cell in accordance with the second embodiment of the present invention is identical to the sensing method of the device for sensing a data in a multibit memory cell in accordance with the first embodiment of the present invention, except the operation of the controlling part 6. That is, the decoder 8a in the second embodiment is applied of, not the clock signal from the clock signal controlling part 5, but the a data signal from the n bit counter 9, in decoding the reference voltage selection signal.

As has been explained, the data sensing device and method for a multibit memory cell of the present invention has the following advantages.

First, since data can be sensed by successive application of reference voltages to a control gate on a multilevel programmed memory cell, which facilitates the sensing amplifier to be merely required to determine generation of a voltage in the multibit memory cell, a size of the sensing amplifier can be minimized.

Second, the requirement for application of only one reference voltage of a certain value to the sensing amplifier helps to reduce a power consumption

It will be apparent to those skilled in the art that various modifications and variations can be made in the data sensing device and method for a multibit memory cell of the present invention without departing from the spirit or scope of the invention Thus, it is intended that the present invention cover the modifications and variations of this invention provided they come within the scope of the appended claims and their equivalents.

## Claims

1. A device for sensing a data in a multibit memory cell (3) comprising:
- a reference voltage generating part (1) for generating a plurality of reference voltages (V_{ref0}, V_{ref1}, ....);
- a switching part (2) for successive application of the plurality of reference voltages (V_{ref0}, Vr_{ef1}, ...) from the reference voltage generating part (1) to a control gate of a memory cell (3);
- a sensing part (4) for producing a signal (Sₒᵤₜ) indicative for channel formation in the memory cell (3) every time one of the reference voltages (V_{ref0}, V_{ref1}, ...) is applied thereto;
- a clock signal controlling part (5) for subjecting the signal (Sₒᵤₜ) from the sensing part (4) and a highest reference voltage selecting signal (Pₙ₋₁) to logical operation in controlling an external main clock signal (CK);
- a controlling part (6) for controlling the switching part (2) to apply the reference voltages (V_{ref0}, V_{ref1}, ...) in succession to the control gate of the memory cell (3), controlling the highest reference voltage selection signal (Pₙ₋₁) to be applied to the clock signal controlling part (5), and to produce data (11) in response to the clock signal (CK) from the clock signal controlling part (5); and
- a latching part (7) for latching the data (11) from the controlling part (6) in response to the signal (Sₒᵤₜ) from the sensing part and in response to the highest reference voltage selection signal (Pₙ₋₁).

2. A device as claimed in claim 1 **characterized in that** the controlling part (6) includes
- a ring counter (8) for counting the clock signal from the clock signal controlling part (5) in controlling production of the reference voltage selection signal in the switching part (2), and
- an n-bit counter (9) for counting the clock signal from the clock signal controlling part (5) in production of a relevant data.

3. A device as claimed in claim 2, **characterized in that** the controlling part (6) includes a decoder (8a) for decoding the plurality of reference voltage selection signals in place of the ring counter (8).

4. A device as claimed in claim 1, **characterized in that** the switching part (2) includes,
- a plurality of transistors (M₁, M₂, ... Mₙ₋₁) for switching the plurality of reference voltages (V_{ref0}, V_{ref2}, ... V_{refn-2}) from the reference voltage generating part (1) in succession in response to the reference voltage selection signal (P₀, P₁, ... Pₙ₋₂) respectively except the highest reference voltage selection signal (Pₙ₋₁) of the reference voltage selection signals from the controlling part (6).
- an OR gate (IC₁) for subjecting the highest reference voltage selection signal (Pₙ₋₁) from the controlling part (6), a signal (Sₒᵤₜ) from the sensing part (4) and a reset signal to logical sum operation, and
- a transistor (Q1) for switching the reference voltages (V_{ref0}, V_{ref1}, ...) applied from the plurality of transistors (M₁, M₂, ...) to an output terminal thereof in response to a signal from the OR gate (IC₁).

5. A device as claimed in claim 4, **characterized in that** the switching part (2) includes a plurality of pass transistors (PTR1, ...) in place of the plurality of transistors (M₁, M₂, ...).

6. A device as claimed in claim 1, **characterized in that** the clock signal controlling part (5) includes,
- a NOR gate (IC₂) for subjecting the highest reference voltage selection signal (Pₙ₋₁) from the controlling part (6) and the signal (Sₒᵤₜ) from the sensing part (4) to logical sum operation and inverting a resultant of the logical sum operation, and
- an AND gate (IC₃) for subjecting a start signal, an external main clock signal and a signal from the NOR gate (IC₂) to logical production operation in applying the clock signal to the controlling part (6).

7. A device as claimed in claim 1, **characterized in that** the latching part (7) includes
- a delay (D1) for delaying the highest reference voltage selection signal (Pₙ₋₁) for a predetermined time period.
- an OR gate (IC₄) for subjecting a signal from the delay (D1) and the signal (Sₒᵤₜ) from the sensing part (4) to logical sum operation, and
- a plurality of flipflops (F/F₀, F/F₁, ...) for latching the data from the n-bit counter (9) in the controlling part (6) using a signal from the OR gate (IC₄) as a clock signal.

8. A method for sensing a data in a multibit memory cell comprising the steps of:
(1) receiving an external main clock signal;
(2) successively producing data by a clock counter (9) in response to the main clock signal;
(3) successively producing reference voltage selecting signals (P₀, P₁, ... Pₙ₋₁) for controlling successive application of a plurality of reference voltages (V_{ref0}, V_{ref1}, ... V_{refn-2}) to a control gate of a memory cell (3);
(4) sensing the memory cell (3) whenever one of the reference voltages (V_{ref0}, V_{ref1}, V_{refn-2}) is applied to the control gate of the memory cell (3);
(5) blocking the main clock signal and latching the data produced by a most recent clock signal
(a) either when an output signal (Sₒᵤₜ) of a sensing part (3) is changed
(b) or when a highest reference voltage selecting signal (Pₙ₋₁) is produced: and
(6) presenting the data latched as a programmed data in the memory cell (3).

9. A method as claimed in claim 8, wherein a number of the reference voltages (V_{ref}) produced is 2ⁿ-1 when the memory cell (3) has been programmed in n bits, and the reference voltages (V_{ref}) are produced in an order from a lower voltage to a higher voltage and data are produced in an order from a lower data to a higher data.

## Patentansprüche

1. Vorrichtung zum Lesen eines Datenwerts in einer Mehrbitspeicherzelle (3), mit:
- einem Bezugsspannungs-Erzeugungsteil (1) zum Erzeugen mehrerer Bezugsspannungen (V_{ref0}, Vref₁, ...);
- einem Schaltteil (2) zum sukzessiven Anlegen der mehreren Bezugsspannungen (V_{ref0}, Vref₁, ...) vom Bezugsspannungs-Erzeugungsteil (1) an ein Steuergate einer Speicherzelle (3);
- einem Leseteil (4) zum Erzeugen eines Signals (S_{OUT}), das einen in der Speicherzelle (3) gebildeten Kanal jedesmal dann anzeigt, wenn eine der Bezugsspannungen (V_{ref0}, Vref₁, ...) an sie angelegt wird;
- einem Taktsignal-Steuerteil (5), um das Signal (S_{OUT}) vom Leseteil (4) und ein Auswählsignal (Pₙ₋₁) für die höchste Bezugsspannung einer logischen Operation beim Steuern eines externen Haupttaktsignals (CK) zu unterziehen;
- einem Steuerteil (6) zum Steuern des Schaltteils (2) zum Anlegen der Bezugsspannungen (V_{ref0}, Vref₁, ...) auf sukzessive Weise an das Steuergate der Speicherzelle (3), zum Steuern des Auswählsignals (Pₙ₋₁) für die höchste Bezugsspannung, das an den Taktsignal-Steuerteil (5) anzulegen ist, und zum Erzeugen eines Datenwerts (11) auf das Taktsignal (CK) vom Taktsignal-Steuerteil (5) hin; und
- einem Latchteil (7) zum Einspeichern des Datenwerts (11) vom Steuerteil (6) auf das Signal (S_{OUT}) vom Leseteil hin und auf das Auswählsignal (Pₙ₋₁) für die höchste Bezugsspannung hin.

2. Vorrichtung nach Anspruch 1, **dadurch gekennzeichnet, dass** der Steuerteil (6) Folgendes aufweist:
- einen Ringzähler (8) zum Zählen des Taktsignals vom Taktsignal-Steuerteil (5) beim Steuern der Erzeugung des Bezugsspannungs-Auswählsignals im Schaltteil (2); und
- einen n-Bit-Zähler (9) zum Zählen des Taktsignals vom Taktsignal-Steuerteil (5) bei der Erzeugung eines relevanten Datenteils.

3. Vorrichtung nach Anspruch 2, **dadurch gekennzeichnet, dass** der Steuerteil (6) über einen Decodierer (8a) zum Decodieren der mehreren Bezugsspannungs-Auswählsignale anstelle des Ringzählers (8) verfügt.

4. Vorrichtung nach Anspruch 1, **dadurch gekennzeichnet, dass** der Schaltteil (2) Folgendes aufweist:
- mehrere Transistoren (M₁, M₂, ..., Mₙ₋₁) zum jeweiligen Schalten der mehreren Bezugsspannungen (V_{ref0}, Vref₂, ...V_{refn-2}) vom Bezugsspannungs-Erzeugungₛteiₗ (1) auf ₛᵤkzessive Weise das Bezugsspannungs-Auswählsignal (P₀, P₁, ... Pₙ-₂) hin mit Ausnahme des höchsten Bezugsspannungs-Auswählsignals (Pₙ₋₁) der Bezugsspannungs-Auswählsignale vom Steuerteil (6);
- ein ODER-Gatter (IC₁) um das höchste Bezugsspannungs-Auswählsignal (Pₙ₋₁) vom Steuerteil (6), ein Signal (S_{OUT}) vom Leseteil (4) und ein Rücksetzsignal einer logischen Summenoperation zu unterziehen; und
- einen Transistor (Q1) zum Schalten der von den mehreren Transistoren (M₁, M₂, ...) angelegten Bezugsspannungen (V_{ref0}, Vref₁, ...) an seinen Ausgangsanschluss auf ein Signal vom ODER-Gatter (IC₁) hin.

5. Vorrichtung nach Anspruch 4, **dadurch gekennzeichnet, dass** der Schaltteil (2) über mehrere Durchlasstransistoren (PTR1, ...) anstelle der mehreren Transistoren (M₁, M₂, ...) verfügt.

6. Vorrichtung nach Anspruch 1, **dadurch gekennzeichnet, dass** der Taktsignal-Steuerteil (5) Folgendes aufweist:
- ein NOR-Gatter (IC₂), um das höchste Bezugsspannungs-Auswählsignal (Pₙ₋₁) vom Steuerteil (6) und das Signal (S_{OUT}) vom Leseteil (4) einer logischen Summenoperation zu unterziehen und das sich aus dieser ergebende Signal zu invertieren; und
- ein UND-Gatter (IC₃), um ein Startsignal, ein externes Haupttaktsignal und ein Signal vom NOR-Gatter (IC₂) beim Anlegen des Taktsignals an den Steuerteil (6) einer logischen Produktoperation zu unterziehen.

7. Vorrichtung nach Anspruch 1, **dadurch gekennzeichnet, dass** der Latchteil (7) Folgendes aufweist:
- eine Verzögerungseinheit (D1), um das höchste Bezugsspannungs-Auswählsignal (Pₙ₋₁) für eine vorbestimmte Zeitperiode zu verzögern;
- ein ODER-Gatter (IC₄), um ein Signal von der Verzögerungseinheit (D1) und das Signal (S_{OUT}) vom Leseteil (4) einer logischen Summenoperation zu unterziehen; und
- mehrere Flipflops (F/F₀, F/F₁, ...), um den Datenwert vom n-Bit-Zähler (9) im Steuerteil (6) unter Verwendung eines Signals vom ODER-Gatter (IC₄) als Taktsignal einzuspeichern.

8. Verfahren zum Lesen eines Datenwerts in einer Mehrbitspeicherzelle, mit den folgenden Schritten:
(1) Empfangen eines externen Haupttaktsignals;
(2) Sukzessives Erzeugen von Daten durch einen Taktsignalzähler (9) auf das Haupttaktsignal hin;
(3) Sukzessives Erzeugen von Bezugsspannungs-Auswählsignalen (P₀, P₁, ..., Pₙ₋₁) zum Steuern des sukzessiven Anlegens mehrerer Bezugsspannungen (V_{ref0}, Vref₁, ..., V_{refn-2}) an ein Steuergate einer Speicherzelle (3);
(4) Lesen der Speicherzelle (3) immer dann, wenn eine der Bezugsspannungen (V_{ref0}, Vref₁, V_{refn-2}) an das Steuergate der Speicherzelle (3) angelegt wird;
(5) Sperren des Haupttaktsignals und Einspeichern des Datenwerts, der durch das jüngste Taktsignal erzeugt wird;
(a) entweder dann, wenn sich das Ausgangssignal (S_{OUT}) eines Leseteils (3) ändert
(b) oder dann, wenn das höchste Bezugsspannungs-Auswählsignal (Pₙ₋₁) erzeugt wird; und
(6) Ausgeben des eingespeicherten Datenwerts als in der Speicherzelle (3) programmierter Datenwert.

9. Verfahren nach Anspruch 8, bei dem die Anzahl der erzeugten Bezugsspannungen (V_{ref}) 2ⁿ-1 beträgt, wenn die Speicherzelle (3) mit n Bits programmiert wurde, und die Bezugsspannungen (V_{ref}) in der Reihenfolge von einer niedrigeren zu einer höheren Spannung erzeugt werden und Daten in einer Reihenfolge von einem niedrigeren zu einem höheren Datenwert erzeugt werden.

## Revendications

1. Dispositif pour détecter des données dans une cellule de mémoire multibit (3) comprenant :
- une partie générant une tension de référence (1) pour générer une pluralité de tensions de référence (V_{ref0}, V_{ref1}, ...) ;
- une partie de commutation (2) pour l'application successive de la pluralité de tensions de référence (V_{ref0}, V_{ref1}, ...) provenant de la partie générant des tensions de référence (1) à une porte de commande d'une cellule de mémoire (3) ;
- une partie de détection (4) pour produire un signal (Sₒᵤₜ) indiquant une formation de canal dans la cellule de mémoire (3) à chaque fois que l'une des tensions de référence (V_{ref0}, V_{ref1}, ...) y est appliquée ;
- une partie de contrôle de signal d'horloge (5) pour soumettre le signal (Sₒᵤₜ) provenant de la partie de détection (4) et un signal de sélection de tension de référence le plus élevé (Pₙ₋₁) à une opération logique de contrôle d'un signal d'horloge principal externe (CK) ;
- une partie de contrôle (6) pour contrôler la partie de commutation (2) pour appliquer les tensions de référence (V_{ref0}, V_{ref1}, ...) en succession à la porte de commande de la cellule de mémoire (3), contrôlant le signal de sélection de tension de référence le plus élevé (Pₙ₋₁) à appliquer à la partie de contrôle de signal d'horloge (5), et pour produire des données (11) en réponse au signal d'horloge (CK) provenant de la partie de contrôle de signal d'horloge (5) ;
et
- une partie de verrouillage (7) pour verrouiller les données (11) provenant de la partie de contrôle (6) en réponse au signal (Sₒᵤₜ) provenant de la partie de détection et en réponse au signal de sélection de tension de référence le plus élevé (Pₙ₋₁).

2. Dispositif selon la revendication 1 **caractérisé en ce que** la partie de contrôle (6) comprend
- un compteur annulaire (8) pour compter le signal d'horloge provenant de la partie de contrôle de signal d'horloge (5) pour contrôler la production du signal de sélection de tension de référence dans la partie de commutation (2), et
- un compteur de bits n (9) pour compter le signal d'horloge provenant de la partie de contrôle de signal d'horloge (5) lors de la production de données pertinentes.

3. Dispositif selon la revendication 2, **caractérisé en ce que** la partie de contrôle (6) comprend un décodeur (8a) pour décoder la pluralité de signaux de sélection de tension de référence à la place du compteur annulaire (8).

4. Dispositif selon la revendication 1, **caractérisé en ce que** la partie de commutation (2) comprend
- une pluralité de transistors (M₁, M₂, ... Mₙ₋₁) pour commuter la pluralité de tensions de référence (V_{ref0}, V_{ref2},...V_{refn2}) provenant de la partie générant des tensions de référence (1) en réponse au signal de sélection de tension de référence (P₀, P₁, ... Pₙ₋₂) respectivement, excepté le signal de sélection de tension de référence le plus élevé (Pₙ₋₁) des signaux de sélection de tension de référence provenant de la partie de contrôle (6),
- une porte OU (IC₁) pour soumettre le signal de sélection de tension de référence plus élevé (Pₙ₋₁) provenant de la partie de contrôle (6), un signal (Sₒᵤₜ) provenant de la partie de détection (4) et un signal de réinitialisation à une opération logique de somme, et
- un transistor (Q1) pour commuter les tensions de référence (V_{ref0}, V_{ref1}, ...) appliquées par la pluralité de transistors (M₁, M₂, ...) à une borne de sortie de ceux-ci en réponse à un signal provenant de la porte OR (IC₁).

5. Dispositif selon la revendication 4, **caractérisé en ce que** la partie de commutation (2) comprend une pluralité de transistors de passage (PTR1,...) à la place de la pluralité de transistors (M₁, M₂, ...).

6. Dispositif selon la revendication 1, **caractérisé en ce que** la partie de contrôle de signal d'horloge (5) comprend
- une porte Non-OU (IC₂) pour soumettre le signal de sélection de tension de référence plus élevé (Pₙ₋₁) provenant de la partie de contrôle (6) et le signal (Sₒᵤₜ) sortant de la partie de détection (4) à une opération logique de somme et pour inverser une résultante de l'opération logique de somme, et
- une porte ET (IC₃) pour soumettre un signal de début, un signal d'horloge externe principal et un signal provenant de la porte Non-OU (IC₂) à une opération logique de production lors de l'application du signal d'horloge à la partie de contrôle (6).

7. Dispositif selon la revendication 1, **caractérisé en ce que** la partie de verrouillage (7) comprend
- un retard (D1) pour retarder le signal de sélection de tension de référence plus élevé (Pₙ₋₁) pendant une période de temps prédéterminée,
- une porte OU (IC₄) pour soumettre un signal provenant du retard (D1) et le signal (Sₒᵤₜ) provenant de la partie de détection (4) à une opération logique de somme, et
- une pluralité de bascules (F/F₀, F/F₁,...) pour verrouiller les données provenant du compteur de bits n (9) au sein de la partie de contrôle (6) en utilisant un signal provenant de la porte OU (IC₄) comme signal d'horloge.

8. Procédé pour détecter des données dans une cellule de mémoire multibit, comprenant les étapes consistant à :
(1) recevoir un signal d'horloge principal externe ;
(2) produire successivement des données par le biais d'un compteur d'horloge (9) en réponse au signal d'horloge principal ;
(3) produire successivement des signaux de sélection de tension de référence ((P₀, P₁, ... Pₙ₋₁) pour contrôler l'application successive d'une pluralité de tensions de référence (V_{ref0}, V_{ref1},...V_{refn2}) à une porte de commande d'une cellule de mémoire (3) ;
(4) détecter la cellule de mémoire (3) lorsque l'une des tensions de référence (V_{ref0}, V_{ref1}, ...) est appliquée à la porte de commande de la cellule de mémoire (3) ;
(5) bloquer le signal d'horloge principal et verrouiller les données produites par un signal d'horloge récent
(a) soit lorsqu'un signal de sortie (Sₒᵤₜ) d'une partie de détection (3) est modifié,
(b) soit lorsqu'un signal de sélection de tension de référence plus élevé (Pₙ₋₁) est produit ;
et
(6) à présenter les données verrouillées comme des données programmées dans la cellule de mémoire (3).

9. Procédé selon la revendication 8, dans lequel un certain nombre des tensions de référence (V_{ref}) produites est 2ⁿ-1 lorsque la cellule de mémoire (3) a été programmée en bits n, et lorsque les tensions de référence (V_{ref}) sont produites dans un ordre allant d'une tension inférieure à une tension supérieure et lorsque les données sont produites dans un ordre allant de données inférieures à des données supérieures.
